# EUROPÄISCHE PATENTSCHRIFT

(11) **EP 1 012 838 B1**
(45) Veröffentlichungstag und Bekanntmachung des Hinweises auf die Patenterteilung: **14.11.2001**
(21) Anmeldenummer: 98945308.9
(22) Anmeldetag: 04.09.1998
(51) Int. Cl.: G11B 7/26, C23C 14/54

(54) **VERFAHREN ZUR REGELUNG EINES BESCHICHTUNGSVORGANGS**
METHOD FOR REGULATING A COATING PROCESS
PROCEDE DE REGULATION D'UN PROCESSUS D'APPLICATION DE REVETEMENT

(30) Priorität: 10.09.1997 DE 19739794
(43) Veröffentlichungstag der Anmeldung: 28.06.2000
(73) Patentinhaber: Steag HamaTech AG, 75447 Sternenfels (DE)
(72) Erfinder: SARBACHER, Uwe, D-76689 Karlsdorf (DE); WINDELN, Wilbert, D-52525 Heinsberg (DE)
(74) Vertreter: Wagner, Karl H., Dipl.-Ing.
(86) Internationale Anmeldenummer: EP9805612
(87) Internationale Veröffentlichungsnummer: WO9913468

(56) Entgegenhaltungen:
- EP-A- 0 205 039
- US-A- 4 457 794
- US-A- 4 975 168
- US-A- 5 151 295

## Beschreibung

Die Erfindung betrifft ein Verfahren zur Regelung eines Beschichtungsvorgangs für das Aufbringen einer Schicht auf ein Substrat.

Beim Aufbringen von Schichten auf ein Substrat ist es bei zahlreichen Fertigungs- und Behandlungsverfahren erforderlich, daß eine bestimmte Schichtdicke geschaffen bzw. eingehalten werden muß. Bei der Herstellung von beispielsweise Compakt Disks (CD's) wird ein Beschichtungsmittel, beispielsweise eine Lackschicht, oder im Falle der Herstellung beschreibbarer CD's, sogenannter CD-R's, ein Farbstoff auf eine sogenannte Kunststoffscheibe mit einem Dispenser aufgebracht, und der Lack oder Farbstoff wird durch Drehen der Scheibe und durch Ausnutzung von Zentrifugalkräften gleichmäßig über der Scheibe verteilt. Während des Beschichtungsverfahrens hängt die Dicke der Beschichtung dabei von vielen Faktoren, beispielsweise von der Art und Konsistenz des Beschichtungsmittels, der herrschenden Temperatur, der Drehzahl oder der Dauer ab, während der sich das Substrat dreht. Es ist daher sehr schwer, über vernünftig lange Zeiträume hinweg, konstante Parameter während des Beschichtungsvorgangs aufrechtzuerhalten, die eine Beschichtung der Substrate mit konstanter Schichtdicke ermöglichen. Zur Überwachung des Beschichtungsvorgangs bzw. der damit geschaffenen Schichtdicken ist es daher bei herkömmlichen Herstellungsverfahren erforderlich, den Fertigungsprozeß zu unterbrechen und durch Stichproben die jeweilige Schichtdicke der aufgebrachten Schicht zu ermitteln und in Abhängigkeit davon die die Schichtdicke beeinflussenden Parameter für das Fertigungsverfahren zu ändern, indem etwa die Drehzahl des Substrats oder die Dauer der Substratdrehung entsprechend geändert wird. Die Produktivität herkömmlicher Beschichtungsverfahren ist daher begrenzt, was insbesondere bei der Herstellung von CD's oder CD-R's als billige Massenprodukte besonders nachteilig ist.

Es ist zwar möglich, die Fertigungsautomaten mit kostspieligen, sehr aufwendigen Meßeinrichtungen, wie zum Beispiel Atomkraftmikroskopie-Meßeinrichtungen zu versehen, um die Schichtdicke während des Beschichtungsvorgangs zu ermitteln und in Abhängkeit davon die Parameter für die Beschichtung zu ändern. Derartige Meßverfahren und Einrichtungen verlangen eine Probenpräparation und benötigen eine lange Meßzeit. Außerdem sind sie nicht nur teuer, sondern insbesondere auch störanfällig und wartungsintensiv, so daß diese Möglichkeit im Zusammenhang mit der Fertigung von beispielsweise CD's als Massenprodukten nicht geeignet ist.

Aus der Druckschrift JP 06-223418 A, Abstract in Datenbank WPI (Derwent) ist eine Vorrichtung bekannt, mit der die Intensität eines gebeugten Lichtstrahls null-ter Ordnung gemessen wird, der erzeugt wird, wenn der Laserstrahl an der Oberfläche eines transparenten Substrats reflektiert wird, welches auf einem Drehteller liegt. Dadurch wird die Dicke einer aufgebrachten Schicht eines optischen Aufzeichnungsmediums gemessen.

Aus der Druckschrift SU 947, 640 B, Abstract in Datenbank WPI (Derwent) ist ein Verfahren zum Messen dünner Schichten bekannt, bei dem die Schicht, deren Dikke gemessen werden soll, selektiv geätzt wird, um einem reflektierten Beugungslichtstrahl zu Messen und daraus auf die Dicke der Schicht zu schließen. Zur Messung der Schicht ist es also erforderlich die Schicht selbst zu verändern. Durch das Ätzen einer Struktur in die zu messende Schicht wird also ein "zerstörendes" Verfahren angewandt.

Aus den Druckschriften H. H. Schlemmer, M. Mächler, J. Phys. E. Sci. Instrum. Vorrichtung. 18, 914 (1985); M. Mächler, M. Schlemmer, Zeiss Inform. 30, Vorrichtung. 16 (1988); US 4 645 349, US 4 984 894, US 4 666 305, WO 96-33387 A1 und EP 0 772 189 A2 sind jeweils Verfahren und Vorrichtungen zum Messen von Schichtdikken bekannt, bei denen jedoch Beugungsvorgänge nicht angewandt und auch Regelungsverfahren im Zusammenhang mit Beschichtungsvorgängen nicht verwendet werden.

Aus der US 4 457 794 ist ein Verfahren zur Herstellung von CD's bekannt. Das Substrat weist Pregrooves auf, und eine Aufzeichnungsschicht wird auf das mit Pregrooves ausgebildeten Substrat aufgebracht. Ein Oberflächenbereich wird mit einem Lichtstrahl aus einer Lichtquelle bestrahlt, das dann auf der anderen Seite des Substrats von einem Photosensor gemessen wird, um die aufgebrachte Schichtdicke zu ermitteln. Die Schichtdicke wird also durch Ermitteln der Lichtdurchlässigkeit der Scheibe ermittelt.

Die US-Patentschrift 4 975 168 zeigt und beschreibt ein Schichtdicken-Meßverfahren bzw. eine Schichtdicken-Meßvorrichtung in Zusammenhang mit einem Sputter-Vorgang zum Aufbringen einer Schicht auf ein Substrat, wobei ein Projektor mit einer Halogen- oder Xenon-Lampe einen Lichtstrahl mit hoher Intensität auf das Substrat abgibt. Der Lichtstrahl wird von einem Spektroskop aufgenommen, nachdem er durch das Substrat und die darauf aufgebrachten Schichten gegangen ist. Die spektrale Verteilung des Lichtstrahls dient als Maß für die Dicke der aufgebrachten Schicht.

Der Erfindung liegt die Aufgabe zugrunde, ein Verfahren zur Regelung eines Beschichtungsvorgangs für das Aufbringen einer Schicht auf ein Substrat zu schaffen, das sehr einfach und wartungsarm ist, kostengünstig angewendet werden kann und eine zuverlässige Ermittlung und/oder Regelung der aufzubringenden Schicht auf ein Substrat während des Beschichtungsvorgangs ermöglicht.

Die gestellte Aufgabe wird erfindungsgemäß durch ein Verfahren zur Regelung eines Beschichtungsvorgangs für das Aufbringen einer Schicht auf ein eine beugende Struktur aufweisendes Substrat gelöst, wobei die Intensität oder die Intensitätsänderung eines auf das beschichtete Substrat fallenden und von dieser gebeugten Lichtstrahls oder Lichtbündels nach seiner Reflexion und/oder Transmission für wenigstens die erste oder eine höhere Ordnung ermittelt und als Ist-Größe für die Regelung der Schichtdicke herangezogen wird. Auf Grund der einfachen Maßnahmen und Bauteile zur Durchführung des erfindungsgemäßen Verfahrens ist eine zuverlässige und kontinuierliche Ermittlung der Schichtdicke während des Beschichtungsvorgangs mit einfachen Mitteln und geringem Aufwand möglich. Auch der Wartungsaufwand einer Vorrichtung zur Durchführung des Verfahrens ist denkbar gering.

Da das Substrat Strukturen aufweist, wie dies beispielsweise durch die sogenannten Pregrooves bei den CD-R's der Fall ist, ist es möglich, die Intensitätsänderung wenigstens eines gebeugten Lichtbündels, beispielsweise der ersten Ordnung oder
der zweiten Ordnung oder auch eine höhere Ordnung des gebeugten Lichtbündels, zu ermitteln, und als Ist- oder Regelwert für die Regelung der Schichtdicke heranzuziehen. Die Intensitätsänderung insbesondere gebeugter Lichtbündel wird nachfolgend anhand von Ausführungsbeispielen im einzelnen erläutert.

Gemäß einer vorteilhaften Ausführungsform der Erfindung wird die Intensität oder die Intensitätsänderung des ungebeugten Lichtbündels ermittelt.

Gemäß einer weiteren sehr vorteilhaften Ausführungsform der Erfindung wird die Intensität bzw. Intensitätsänderung des ungebeugten und/oder gebeugten Lichtbündels für wenigstens eine Wellenlänge des Lichtbündels ermittelt. Durch die Beschränkung auf eine oder wenige Wellenlängen des Lichtbündels ist in bestimmten Anwendungsfällen eine definiertere Intensitätsermittlung möglich.

Besonders vorteilhaft ist es jedoch, die Intensität und/oder die Intensitätsänderung für mehrere Wellenlängen gleichzeitig zu messen, wodurch Mehrdeutigkeiten durch Interferenzeffekte vermieden werden können.

Die Intensität oder die Intensitätsänderung des gebeugten Lichtbündels ist in Transmission und/oder in Reflexion durchführbar.

Gemäß einer weiteren vorteilhaften Ausführungsform der Erfindung ist zur Regelung eines Beschichtungsvorgangs nicht nur die absolute Intensität bzw. die absolute Intensitätsänderung des reflektierten und/oder transmittierten Lichtbündels, sondern auch die Ermittlung der relativen Intensität bzw. Intensitätsänderung möglich und vorteilhaft. Dabei wird das Verhältnis der Intensitäten des Ausgangs- und des Eingangslichtbündels bestimmt und als Ist- bzw. Regelwert herangezogen.

Gemäß einer weiteren Ausführungsform wird die spektrale Verteilung und/oder die Änderung der spektralen Verteilung eines auf das beschichtete Substrat fallenden Lichtbündels nach seiner Reflexion und/oder Transmission ermittelt und als Ist-Wert für die Regelung der Schichtdicke herangezogen wird. Auch im Falle der Ermittlung der spektralen Verteilung und/oder der Änderung der spektralen Verteilung ist dies bei ungebeugtem Lichtbündel oder auch bei gebeugtem Lichtbündel möglich, wobei die spektrale Verteilung oder deren Änderung im letzeren Fall nicht nur für eine Ordnung, etwa die nullte oder die erste Ordnung, sondern auch für mehrere Ordnungen möglich und vorteilhaft ist. Als Empfänger werden im Falle der Ermittlung der spektralen Verteilung oder ihrer Änderung vorzugsweise Spektralphotometer verwendet.

Vorteilhafterweise werden als Lichtquellen Laser, lichtemittierende Dioden (LED's), Spektrallampen, Halogenlampen oder thermische Strahler je nach dem Anwendungsfall und den Gegebenheiten verwendet. Es ist auch vorteilhaft, das von einer Lichtquelle abgegebene inkohärente Lichtspektral zu filtern.

Gemäß einer vorteilhaften Ausführungsform der Erfindung sind für die Ziel- oder Soll-Werte im Zusammenhang mit der Regelung Erfahrungswerte vorgesehen. Um zeitaufwendige und mühsame Untersuchungen und vorausgehende Beschichtungsvorgänge zur Ermittlung dieser Eefahrungswerte zu vermeiden, ist es auch vorteilhaft, als Ziel- oder Soll-Werte für die Regelung berechnete Werte zu verwenden. Insbesondere bei einem Wechsel des Substrats und/oder des Beschichtungsmaterials und der damit notwendigen neuen Auslegung des Schichtprofils kann eine Ermittlung von Erfahrungswerten für den Soll-Wert der Regelung zeitlich sehr aufwendig sein. Die Zielgrößen für die Regelung sind daher zur Zeitersparnis vorteilhafterweise für ein vorgegebenes Schichtprofil rechnerisch zu ermitteln. Hierbei ist es vorteilhaft, an sich bekannte Rechenmethoden im Zusammenhang mit der Optik dieser Schichten zu verwenden, wie dies beispielsweise aus Born & Wolf, Principles of Optics, 6 Edition, Pergamon Press, insbesondere Seiten 51-70 bekannt ist.

Im Zusammenhang mit der Beschichtung von strukturierten Substraten, beispielsweise für die Fertigung von CD-R's, bei denen das Kunststoffsubstrat zur Ausbildung der Pregrooves-Geometrie mit einem Spritzgußwerkzeug gefertigt wird, ist es darüber hinaus vorteilhaft, eine rechnerische Korrektur der Abnutzung des Spritzgußwerkzeugs vorzunehmen, die sich in der Geometrie, beispielsweise der Tiefe der Pregroove bei der Herstellung einer großen Anzahl von Kunststoffsubstraten bemerkbar macht.

Die Erfindung sowie deren Ausgestaltung und Vorteile wird bzw. werden nachfolgend am Beispiel der Beschichtung einer CD-R unter Bezugnahme auf die Figuren erläutert. Es zeigen:
- Fig. 1: einen schematischen Querschnitt durch einen Ausschnitt eines beschichteten Substrats für eine CD-R, und
- Fig. 2: eine schematische Darstellung des erfindunggemäßen Verfahrens in Zusammenhang mit der Beschichtung eines eine Pregroove-Geometrie aufweisenden Substrats für die CD-R-Fertigung.

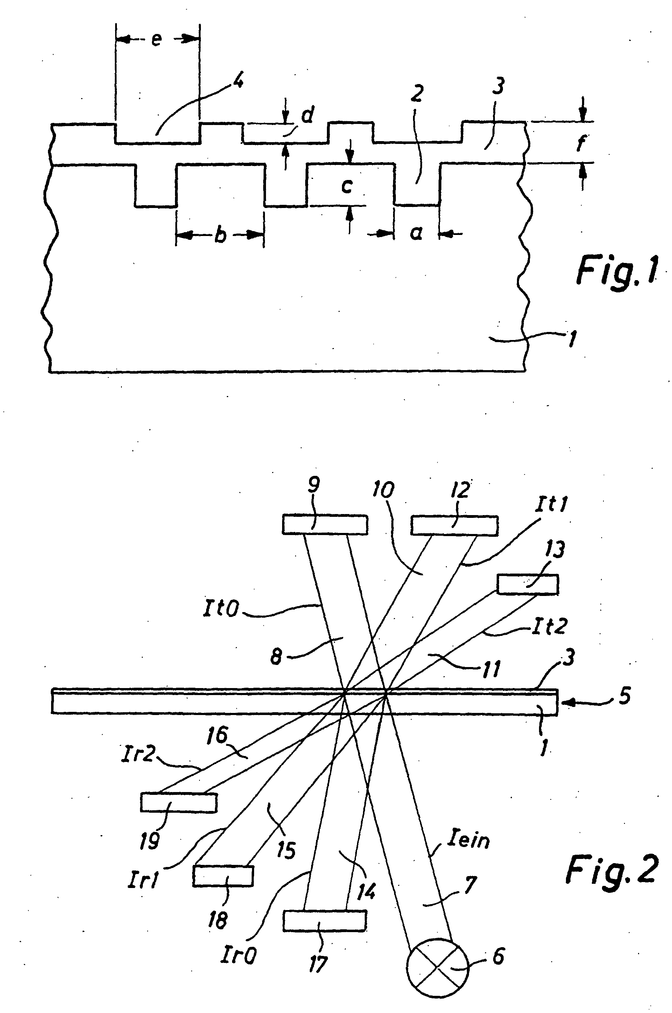

Wie Fig. 1 zeigt, ist ein Substrat auf seiner oberen Seite mit einer sogenannten Pregroove-Geometrie etwa durch Spritzgießen des Substrats 1 ausgebildet. Bei diesem Ausführungsbeispiel weist die obere Fläche des Substrats 1 sogenannte Pregrooves 2 mit einer Breite a von ca. 450 nm mit einem konstanten Abstand b von ca. 1600 nm zueinander auf, wobei die Pregrooves 2 mit dem konstanten Abstand b zueinander spiralförmig verlaufen. Die Pregrooves 2 weisen eine Tiefe c auf die typischerweise in einem Bereich zwischen 50 und 200 nm liegt. Auf dem Substrat 1 befindet sich eine aufgebrachte Farbstoff- oder Dye-Schicht 3, die sich im wesentlichen über die gesamte Fläche des Substrats 1 erstreckt und auch die Pregrooves 2 des Substrats 1 ausfüllt. Über den vom Farbstoff ausgefüllten Pregrooves 2 ergibt such jeweils die sogenannte Groove 4 als Einsenkung, die bei Absenken des Farbstoffs in die Pregrooves 2 des Substrats 1 entstehen und beim Schreiben und Lesen der CD-R als Spur dienen. Obgleich die Darstellung eine rechtwinkliges Form der Groove 4 mit der Groovebreite zeigt, besteht üblicherweise ein schräger oder allmählicher Übergang vom Scheitel zur Sohle. Die Tiefe der Groove 3 ist mit d bezeichnet, während die Dicke der Farbstoffschicht 3 in den Bereichen außerhalb der Pregroove 2 bzw. der Groove 4 mit dem Bezugszeichen f versehen ist.

Die Struktur und Ausbildung einer CD-R sowie deren Pregroove-Geometrie und der aufgebrachten Farbstoffschicht ist allgemein bekannt und beispielsweise in dem Artikel Holstlag et al, Jpn. J. Appl. Phys. Volume 31 Part I, Nr. 2B (1992), Seiten 484-493 beschrieben. Um Wiederholungen zu vermeiden; wird auf diese Druckschrift verwiesen und sie insofern zum Inhalt der vorliegenden Anmeldung gemacht.

Fig. 2 zeigt die CD-R 5 mit dem Substrat 1 und der Farbstoffschicht 3 in schematischer Darstellung. Eine Lichtquelle 6 sendet einen Eingangs-Lichtstrahl oder - bündel 7 in einer Intensität ein von unten auf die CD-R 5, der bzw. das durch sie hindurchgeht und als ungebeugtes Transmissionlichtbündel 8 mit der Intensität ItO, also als Transmissionstrahl der Beugungsordnung O, auf einen Empfänger 9, beispielsweise ein Spektralphotometer, auftrifft, und deren Intensität gemessen wird. Der auf die CD-R 5 von unten auffallende Eingangs-Lichtstrahl 7 wird jedoch auch an den Pregrooves 2 gebeugt, die auf Grund ihres gleichmäßigen Abstands b ein Beugungsgitter bilden. Dadurch entsteht das Transmissionslichtbündel 10 erster Ordnung mit der Intensität It1 und das Transmissionslichtbündel 11 mit der Intensität It2, die auf jeweils einen weiteren Empfänger 12 bzw. 13 zur Messung deren Intensität fallen und ebenfalls Spektralphotometer sein können. Das Eingangslichtbündel 7 wird jedoch auch in der CD-R 5 am Übergang zwischen Substrat 1 und Farbstoffschicht 3 (teil-)reflektiert, so daß entsprechend den Transmissionslichtbündeln 8, 10 und 11 Reflexionslichtbündel 14, 15, 16 entstehen, die auf entsprechende Empfänger oder Detektoren 17, 18, 19 fallen. Das Reflexionslichtbündel 14 ist ungebeugt und weist die Intensität Ir0 auf. Das Reflexionsbündel 10 ist der Beugungslichtstrahl erster Ordnung mit der Intensität Ir1 und das Reflexionslichtbündel 16 ist der Beugungsstrahl zweiter Ordnung mit der Intensität Ir2. Selbstverständlich kann man den Strahlengang auch umkehren. Dann fällt der Eingangs-Lichtstrahl oder das -bündel 7 der Lichtquelle 6 von der Seite der Farbstoffschicht 3 auf die CD-R 5. Viele Farbstoffschichten transmittieren auf bestimmten Wellenlängen nur so wenig Licht, daß die zusätzlichen Reflexe z.B. am Übergang zwischen Substrat 1 und Farbstoffschicht 3 sehr schwach werden. Die Messung wird dann durch diese Reflexe praktisch nicht mehr beeinflußt.

Der komplexe Berechnungsindex des Materials der Farbstoffschicht 3 als Funktion der Wellenlänge ist bekannt bzw. mit bekannten Verfahren meßbar. Darüber hinaus ist die Geometrie der Pregrooves 2 und deren Verlauf im Substrat 1, also die Beite a und die Tiefe c der Pregroove 2 sowie deren Abstand b voneinander bekannt. Die Pregroove-Geometrie ändert sich durch die Abnützung des Spritzgußwerkzeuges nur langsam. Die Änderung der Pregroove-Geometrie ist daher für die Ermittlung der Dicke der Farbstoffschicht 3 auf einfache Weise von Zeit zu Zeit zu kontrollieren, wenn sie nicht ohnehin vernachläßigbar ist.

Dagegen ist das Oberflächenrelief der Farbstoffschicht 3 nicht bekannt, das durch die periodische Struktur der Grooves 4 mit der Groovetiefe d und der Groovebreite e (vergleiche Fig. 1) gebildet wird.

Dieses Oberflächenrelief der Farbstoffschicht 3, d. h. die Tiefe d und die Breite e der Groove 4 sind jedoch durch die Lichtbündelintensitäten It0, It1 und It2 der transmittierten Lichtbündel 8, 10 und 11 und/oder durch die Intensitäten IrO, Ir1 und Ir2 der reflektierten Lichtbündel 14, 15 und 16 meß- und feststellbar.

Lediglich der Vollständigkeit halber wird darauf hingewiesen, daß die Eindeutigkeit der Meßgrößen It0, It1 und It2, sowie IrO, Ir1 und Ir2 auf Phasendifferenzen beschränkt ist, die kleiner als die Hälfte der verwendeten Lichtwellenlänge ist. Da die Tiefe e der Groove 4 jedoch üblicherweise zwischen 50 nm und 200 nm liegt, bedeutet dies jedenfalls dann in der Praxis und insbesondere bei Transmission des Lichtbündels keine Einschränkung, wenn Licht mit einer Wellenlänge über etwa 600 nm verwendet wird. Dabei ist es unerheblich, ob die gebeugten Lichtbündel in Transmission oder in Reflexion gemessen werden. Bei Messungen in Transmission ist die Phasenverschiebung im Dickenintervall 0 bis 300nm deutlich kleiner als die Hälfte der Lichtwellenlängen des sichtbaren Spektralbereiches. Bei Messungen in Reflexion ergaben sich für diesen Spektralbereich insbesondere bei Beleuchtung von der Substratseite Mehrdeutigkeiten. Diese können nur durch Vorabkenntnis des im Prozeß enger gefaßten Tiefenbereichs ausgeräumt werden. Der nutzbare Tiefenbereich kann in diesem Fall dadurch erweitert werden, daß man auf verschiedenen Wellenlängen gleichzeitig mißt.

Nachdem die Pregroove-Geometrie des Substrats 1, also die Breite a und die Tiefe b der Pregrooves 2 bekannt und konstant ist, und die Geometrie der Farbstoffschicht 3, also die Tiefe d und die Breite e der Groove 4 gemessen werden können, ist nur noch die konstante Dicke f der Farbstoffschicht 3 unbekannt, die bei dem Beschichtungsvorgang festgelegt und geregelt werden muß. Diese Dicke f beeinflußt bei einer Veränderung während des Aufbringens der Farbstoffschicht 3 die Absorption des transmittierten, nicht gebeugten Lichtbündels, und damit das Verhältnis der Intensität It0 des transmittierten Lichtbündels nullter Ordnung und der Intensität lein des einfallenden Lichtbündels 7. Durch Messung dieses Verhältnisses ergibt sich daher ein Maß für die Dicke f der Farbstoffschicht 3 und ein Regel-Ist-Wert zur Regelung von Parametern des Beschichtungsvorgangs, beispielsweise eine Regelung der Temperatur des aufzubringenden Farbstoffs, oder der Drehzahl oder Zeitdauer der Substrat-Drehung.

Sollte die Gefahr von Mehrdeutigkeiten des Meßverhältnisses It0/lein durch Interferenzeffekte bestehen, ist es zusätzlich vorteilhaft und sinnvoll, It0/lein für mehrere Wellenlängen etwa durch Einsatz eines Spekralphotometers gleichzeitig zu messen.

Für die Ziel- oder Soll-Größen bei der Regelung genügt es, wenn Erfahrungs- oder empirische Werte vorgegeben werden. Eine numerische Bestimmung der Größen d, e und f ist für eine Regelung an sich nicht erforderlich. Die Ermittlung solcher empirischer oder Erfahrungswerte kann jedoch sehr zeitraubend sein. Insbesondere bei einem Wechsel des Farbstoff-Typs ist eine neue Auslegung des Schichtprofils notwendig. Aus Zeitersparnis-Gründen ist es dann vorteilhaft, die Zielgrößen für ein vorgegebenes Schichtprofil numerisch zu ermitteln. Zu diesem Zweck wird die Transmission durch das Substrat 1 und die Farbstoffschicht 3 nach herkömmlichen Rechen-Verfahren für dünne Schichten ortsaufgelöst für eine Periode der periodischen Struktur berechnet. Anschließend erfolgt für die berechneten, komplexen Amplituden eine Zerlegung in ebene Wellen, d. h. es wird eine Fourier-Transformation durchgeführt. Das Betragsquadrat der Amplitude der ebenen Wellen liefert die Intensität der einzelnen Beugungsordnungen. Diese vereinfachte Vorgehensweise ist physikalisch nicht exakt, da die Kopplung der Wellen verschiedener Ordnungen nicht herücksichtigt sind. Es ergeben sich dennoch für die Praxis ausreichende Genauigkeiten, da die Tiefe der Strukturen, also die Werte c bzw. d, höchstens 200 nm betragen, also viel geringer sind als ihre Periodizität, d. h. der Pregrooves 2 bzw. der Grooves 4 von 1600 nm zueinander.

Die Erfindung wurde zuvor anhand eines Ausführungsbeispiels im Zusammenhang mit CD-R's beschrieben. Dem Fachmann sind jedoch Abwandlungen und Ausgestaltungen möglich, ohne daß dadurch der Erfindungsgedanke verlassen wird. Darüber hinaus ist es auch möglich, durch entsprechenden Einsatz des 5 erfindungsgemäßen Verfahrens an verschiedenen Stellen eines Substrats festzustellen, ob die Schichtdicke über die gesamte Fläche hinweg gleich ist.

## Patentansprüche

1. Verfahren zur Regelung eines Beschichtungsvorgangs für das Aufbringen einer Schicht (3) auf ein eine beugende Struktur (2) aufweisendes Substrat (1), wobei die Intensität eines auf das beschichtete Substrat fallenden und von dieser gebeugten Lichtbündels (7) nach seiner Transmission und/oder Reflexion für wenigstens die erste oder eine höhere Ordnung ermittelt und als Ist-Größe für die Regelung der Schichtdicke herangezogen wird.

2. Verfahren nach Anspruch 1, **dadurch gekennzeichnet, daß** die Intensität auch für eine Wellenlänge des ungebeugten Lichtsbündels ermittelt wird.

3. Verfahren nach einem der vorhergehenden Ansprüche, **dadurch gekennzeichnet, daß** die Intensität für mehrere Wellenlängen gleichzeitig ermittelt werden.

4. Verfahren nach einem der vorhergehenden Ansprüche, **dadurch gekennzeichnet, daß** die Intensitätsänderung des reflektierten und/oder transmittierten Lichtbündels ermittelt wird.

5. Verfahren nach einem der vorhergehenden Ansprüche, **dadurch gekennzeichnet, daß** ein Laserlichtbündel verwendet wird.

6. Verfahren nach einem der vorhergehenden Ansprüche, **dadurch gekennzeichnet, daß** ein von einer inkohärenten Lichtquelle (6) abgegebenes Lichtbündel (7) verwendet wird.

7. Verfahren nach Anspruch 6, **dadurch gekennzeichnet, daß** die inkohärente Lichtquelle (6) eine lichtemittierende Diode, eine Spektrallampe, eine Halogenlampe oder ein thermischer Strahler ist.

8. Verfahren nach einem der vorhergehenden Ansprüche, **dadurch gekennzeichnet, daß** das Licht spektral gefiltert wird.

9. Verfahren nach einem der vorhergehenden Ansprüche, **dadurch gekennzeichnet, daß** als Zielwerte für die Regelung Erfahrungswerte verwendet werden.

10. Verfahren nach einem der Ansprüche 1 bis 8, **dadurch gekennzeichnet; daß** als Zielwerte für die Regelung berechnete Werte verwendet werden.

11. Verfahren nach einem der vorhergehenden Ansprüche, **dadurch gekennzeichnet, daß** das Substrat (1) eine Kunststoffscheibe ist.

12. Verfahren nach einem der vorhergehenden Ansprüche, **dadurch gekennzeichnet, daß** die aufzubringende Schicht (3) aus einem Farbstoff besteht.

13. Verwendung des Verfahrens nach einem der vorhergehenden Ansprüche, zur Herstellung von Compakt Disks (CD's).

14. Verwendung des Verfahrens nach einem der Ansprüche 1 bis 15 zur Herstellung von beschreibbaren Compakt Disks (CD-R's).

## Claims

1. Method for regulating a coating process for the application of a layer (3) to a substrate having a diffracting structure (2), wherein the intensity of a light bundle (7) incident on and diffracted by the coated substrate is determined after its transmission and/or reflection for at least the first or a higher order and is utilized as an actual value for regulation of the layer thickness.

2. Method according to claim 1, **characterised in that** the intensity of the non-diffracted light beam is determined also for one wavelength.

3. Method according to one of the preceding claims, **characterised in that** the intensity is determined for several wavelengths simultaneously.

4. Method according to one of the preceding claims, **characterised in that** the intensity change of the refracted and/or transmitted light bundle is determined.

5. Method according to one of the preceding claims, **characterised in that** a laser light bundle is used.

6. Method according to one of the preceding claims, **characterised in that** a light beam (7) emitted by an incoherent light source (6) is used.

7. Method according to claim 6, **characterised in that** the incoherent light source (6) is a light-emitting diode, a spectral lamp, a halogen lamp or a thermal radiator.

8. Method according to one of the preceding claims, **characterised in that** the light is spectrally filtered.

9. Method according to one of the preceding claims, **characterised in that** observed values are used as target values for the regulation.

10. Method according to one of claims 1 to 8, **characterised in that** calculated values are used as target values for the regulation.

11. Method according to one of the preceding claims, **characterised in that** the substrate (11) is a plastics material disc.

12. Method according to one of the preceding claims, **characterised in that** the layer (3) to be applied consists of a pigment.

13. Use of the method according to one of the preceding claims for the manufacture of compact discs (CD's).

14. Use of the method according to one of claims 1 to 13 for the manufacture of recordable compact discs (CD-R's).

## Revendications

1. Procédé pour régler une opération d'enduction pour appliquer une couche (3) à un substrat (1) présentant une structure diffractive (2), où l'intensité d'un faisceau de lumière (7) tombant sur le substrat enduit et diffracté par celui-ci est déterminée après sa transmission et/ou réflexion pour au moins le premier ordre ou un ordre plus élevé et est utilisée comme grandeur réelle pour le réglage de l'épaisseur de couche.

2. Procédé selon la revendication 1, **caractérisé en ce que** l'intensité est déterminée également pour une longueur d'onde du faisceau de lumière non diffracté.

3. Procédé selon l'une des revendications précédentes, **caractérisé en ce que** l'intensité pour plusieurs longueurs d'onde est déterminée simultanément.

4. Procédé selon l'une des revendications précédentes, **caractérisé en ce que** la modification d'intensité du faisceau de lumière réfléchi et/ou transmis est déterminée.

5. Procédé selon l'une des revendications précédentes, **caractérisé en ce qu'**un faisceau de lumière laser est utilisé.

6. Procédé selon l'une des revendications précédentes, **caractérisé en ce qu'**un faisceau de lumière (7) émis par une source de lumière incohérente (6) est utilisé.

7. Procédé selon la revendication 6, **caractérisé en ce que** la source de lumière incohérente (6) est une diode émettrice de lumière, une lampe spectrale, une lampe halogène ou un émetteur de rayonnement thermique.

8. Procédé selon l'une des revendications précédentes, **caractérisé en ce que** la lumière est filtrée spectralement.

9. Procédé selon l'une des revendications précédentes, **caractérisé en ce que** des valeurs empiriques sont utilisées comme valeurs de cible pour le réglage.

10. Procédé selon l'une des revendications 1 à 8,
**caractérisé en ce que** des valeurs calculées pour le réglage sont utilisées comme valeurs de cible.

11. Procédé selon l'une des revendications précédentes, **caractérisé en ce que** le substrat (1) est un disque en matière synthétique.

12. Procédé selon l'une des revendications précédentes, **caractérisé en ce que** la couche (3) à appliquer est constituée d'un colorant.

13. Utilisation du procédé selon l'une des revendications précédentes, pour la fabrication de disques compacts (CDs).

14. Utilisation du procédé selon l'une des revendications 1 à 15 pour la fabrication de disques compacts inscriptibles (CD-Rs).
